# EUROPEAN PATENT APPLICATION

(11) **EP 3 386 281 A1**
(43) Date of publication of application: **10.10.2018**
(21) Application number: 17779193.6
(22) Date of filing: 06.04.2017
(51) Int. Cl.: H05K 3/34, H05K 1/02

(54) **WIRING SUBSTRATE, ELECTRONIC-COMPONENT-ATTACHED WIRING SUBSTRATE, AND METHOD FOR MANUFACTURING ELECTRONIC-COMPONENT-ATTACHED WIRING SUBSTRATE**

(30) Priority: 06.04.2016 JP 2016076621
(71) Applicant: Mitsubishi Heavy Industries Thermal Systems, Ltd., Tokyo 108-8215 (JP)
(72) Inventor: ADACHI, Naoya, Tokyo 108-8215 (JP)
(74) Representative: Henkel, Breuer & Partner
(86) International application number: PCT/JP2017/014313
(87) International publication number: WO 2017/175815

(57) **Abstract**

The present invention includes, on one surface (21a) of an insulating substrate (21): a first land group (23) having a plurality of first lands that are provided in a manner spaced apart from one another in an X direction and that include first insertion holes (21A) passing through the insulating substrate (21); a first solder-retaining land section (26) provided adjacently to a first edge land (23C); and a first barrier section (31) that is provided on the one surface (21a) of the insulating substrate (21) so as to separate at least the first edge land (23C) and the first solder-retaining land section (26) in the X direction and that has solder repelling properties.

## Description

### Technical Field

The present invention relates to a wiring substrate on which an electronic component having a plurality of lead terminals is mounted, an electronic-component-attached wiring substrate, and a method for manufacturing an electronic-component-attached wiring substrate.

This application claims priority to Japanese Patent Application No. 2016-076621 filed in Japan on April 6, 2016, and the content of which is incorporated herein by reference.

### Background Art

In the related art, there is an electronic-component-attached wiring substrate including a wiring substrate including an insulating substrate and a plurality of lands having insertion holes which are provided in a first direction on one surface of the insulating substrate and through which lead terminals of an electronic component are inserted, an electronic component having a plurality of the lead terminals to be inserted into the insertion holes, and a solder fixing the lands and the lead terminals (for example, see PTL 1).

The electronic-component-attached wiring substrate having such a configuration is also used in the indoor unit or the like of an air conditioner having a small substrate.

In a case where the electronic component is mounted on the wiring substrate, a flow soldering method is used which dips the side having a plurality of lands formed thereon in the molten solder, while transporting the wiring substrate in a tilted state, in a state where the lead terminals of the electronic component are inserted into the insertion holes from the other side of the insulating substrate.

In a case of using such a flow soldering method, since the solder tends to be retained in the land (hereinafter, referred to as "end land") located on the rear end side in the transport direction of the wiring substrate, among the plurality of lands, there is a problem that solder bridge tends to occur in this part.

Therefore, from the viewpoint of suppressing the occurrence of solder bridges, in the related art, a solder-retaining land capable of retaining the solder is provided in a position adjacent to the end land (for example, see PTL 2.)

In PTL 2, a printed wiring substrate having a solder-retaining land at a position spaced from the end land is disclosed.

### Citation List

### Patent Literature

[PTL 1] Japanese Unexamined Patent Application Publication No. 2010-129813
[PTL 2] Japanese Unexamined Patent Application Publication No. 11-126960

### Summary of Invention

### Technical Problem

As in PTL 2, by providing the solder-retaining lands, it is possible to suppress the occurrence of solder bridges in the transport direction of the wiring substrate to some extend.

However, in the technique disclosed in PTL 2, since there is no any barrier around the end lands, it is difficult to sufficiently suppress the occurrence of solder bridges.

Incidentally, it is conceivable to suppress the solder bridge by increasing the area of the solder-retaining land, but it leads to an increase in the size of the wiring substrate, and thus it is not preferable.

In particular, it is not preferable for the wiring substrate applied to the indoor unit of an air conditioner with a small substrate.

Thus, an object of the present invention is to provi de a wiring substrate, an electronic-component-attached wiring substrate, and a method for manufacturing an electronic-component-attached wiring substrate, by which it is possible to suff iciently suppress the occurrence of solder bridges around the end lands, while suppressing an increase in the size o f the wiring substrate.

### Solution to Problem

In order to solve the above problems, a wiring substrate according to an aspect of the present invention includes an insulating substrate; a first land group including a plurality of first lands having first insertion holes respectively which are provided in a manner spaced apart from one another in a first direction, on one surface of the insulating substrate, which penetrate the insulating substrate, and through which lead terminals are inserted; a first solder-retaining land section that is provided adjacent to a first end land disposed at an end in the first direction, among the plurality of first lands; and a first barrier section that is provided on the one surface of the insulating substrate so as to separate at least the first end land and the first solder-retaining land section in the first direction and that has solder repelling properties.

According to the present invention, since the first end land and the first solder-retaining land section are separated from each other, as compared with the land in which the first end land and the first solder-retaining land section are integrally formed, it is possible to reduce the amount of solder retained in the first solder-retaining land section.

Thus, the solder retained in the first solder-retaining land section can be prevented from easily moving to the first end land.

By providing the first barrier section that separates the first end land and the first solder-retaining land section and has the solder repelling properties, the solder retained in the first solder-retaining land section can be prevented from moving to the first end land, without increasing the area of the first solder-retaining land section.

Thus, it is possible to sufficiently suppress the occurrence of solder bridges between the lands disposed around the first end land.

That is, it is possible to sufficiently suppress the occurrence of solder bridges around the first end land, while suppressing an increase in the size of the wiring substrate.

Further, in the wiring substrate according to the aspect of the present invention, the first barrier section may be disposed so as to continuously surround the periphery of the first end land.

With such a structure, it is possible to further suppress the occurrence of solder bridges between the lands disposed around the first end land and the first end land.

Further, the wiring substrate according to the aspect of the present invention may include a second land group including a plurality of second lands having second insertion holes respectively which are provided in a manner spaced apart from one another along the first land group in the first direction, on the one surface of the insulating substrate, which penetrate the insulating substrate, and through which lead terminals are inserted; a second solder-retaining land section that is provided at the end in the first direction and is provided adjacent to a second end land that is disposed opposite the first end land in a second direction crossing the first direction, among the plurality of second lands; and a second barrier section that is provided on the one surface of the insulating substrate, disposed so as to separate the first solder-retaining land section and the second solder-retaining land section, and is connected to the first barrier section, in which the second barrier section has the solder repelling properties.

In this way, by providing the second barrier section that separates the first solder-retaining land section and the second solder-retaining land section and has the solder repelling properties, it is possible to suppress the occurrence of solder bridges between the first solder-retaining land section and the second solder-retaining land section.

Further, in the wiring substrate according to the aspect of the present invention, the first end land and the first solder-retaining land section may have the same potential, the second end land and the second solder-retaining land section may have the same potential as each other, and may have different potentials from the first end land and the first solder-retaining land section.

With such a structure, it is possible to suppress the occurrence of short circuit caused by solder between the second end land provided around the first end land, and the second land and the first end land.

In addition, since the first end land and the first solder-retaining land section have the same potential, even if a solder bridge occurs between the first end land and the first solder-retaining land section, it does not become a problem.

Further, the wiring substrate according to the aspect of the present invention may further include a third barrier section that is provided on the one surface of the insulating substrate so as to separate at least the second end land and the second solder-retaining land section in the first direction and that has solder repelling properties.

In this way, since the second end land and the second solder-retaining land section are separated by providing the third barrier section that separates the second end land and the second solder-retaining land section and has the solder repelling properties, the solder retained in the second solder-retaining land section can be prevented from moving to the second end land, without increasing the area of the second solder-retaining land section.

Thus, it is possible to suppress the occurrence of solder bridges between the second solder-retaining land section and the second end land, while suppressing an increase in the size of the wiring substrate.

Further, in the wiring substrate according to the aspect of the present invention, both ends of the third barrier section are connected to the first barrier section, and a structure including the first and third barrier sections may surround the second end land.

With such a structure, it is possible to suppress the occurrence of solder bridges between the lands provided around the second end land and the second end land.

In order to solve the above problems, an electronic-component-attached wiring substrate according to another aspect of the present invention includes the wiring substrate; an electronic component including a plurality of the lead terminals projecting from the other surface of the insulating substrate while being inserted into the first and second insertion holes; and solders provided in the plurality of first lands, the plurality of second lands, the first solder-retaining land section, and the second solder-retaining land section.

The electronic-component-attached wiring substrate with such a structure can sufficiently suppress the occurrence of solder bridges between the lands disposed around the first end land and the first end land.

In order to solve the above problems, a method for manufacturing an electronic-component-attached wiring substrate according to still another aspect of the present invention includes a first step of collectively forming a first land group including a plurality of first lands having first insertion holes respectively which penetrate an insulating substrate, and through which lead terminals are inserted, on one surface of the insulating substrate; a second land group including a plurality of second lands having second insertion holes which penetrate the insulating substrate and through which lead terminals are inserted; a first solder-retaining land section spaced from a first end land disposed at an end in the first direction, among the plurality of first lands; and a second solder-retaining land section that is disposed at a position adjacent to a second end land disposed at an end in the first direction, among the plurality of second lands; a second step of collectively forming a first barrier section that separates at least the first end land and the first solder-retaining land section in the first direction and has solder repelling properties and a second barrier section that separates at least the second end land and the second solder-retaining land section and has solder repelling properties; a third step of inserting the lead terminals of an electronic component into the first and second insertion holes from the other surface side of the insulating substrate, and causing the lead terminals to project from the plurality of first and second lands including the first and second end lands provided on the one surface side of the insulating substrate; and a fourth step of attaching a molten solder to the plurality of first and second lands including the first and second end lands, while transporting a wiring substrate to which the electronic component is inserted in a predetermined direction, in a state where the wiring substrate is tilted, by a solder flow method, in which in the fourth step, the wiring substrate is transported in the transport direction of the wiring substrate such that the first and second solder-retaining land sections are located at the rear end.

Since the plurality of first and second lands including the first and second end lands are formed by transporting the wiring substrate to which the electronic component is inserted in the transport direction of the wiring substrate such that the first and second solder-retaining land sections are positioned on the rear end side, it becomes possible to prevent the solder retained in the first solder-retaining land section from moving to the adjacent land, without increasing the area of the first solder-retaining land section.

Thus, it is possible to sufficiently suppress the occurrence of solder bridges around the first end land, while suppressing an increase in the size of the wiring substrate.

Further, in the method for manufacturing an electronic-component-attached wiring substrate according to the aspect of the present invention, in the second step, the first barrier section may be formed so as to surround the first end land.

Thus, it is possible to further suppress the occurrence of solder bridges between the lands provided around the first end land and the first end land.

Further, in the method for manufacturing an electronic-component-attached wiring substrate according to the aspect of the present invention, the first barrier section and the second barrier section may be made by a printing method using a silk material.

In general, the silk material is a material used to print the position to mount the electronic component, or the number on the surface of the insulating substrate. Therefore, since the first and second barrier sections are formed by using a silk material that has been used from the past, there is no need to prepare separately materials for forming the first and second barrier sections, such that it is possible to conveniently form the first and second barrier sections.

### Advantageous Effects of Invention

According to the present invention, it is possible to sufficiently suppress the occurrence of solder bridges around the end lands provided on the wiring substrate, while suppressing an increase in the size of the wiring substrate.

### Brief Description of Drawings

Fig. 1 is a cross-sectional view schematically illustrating an end portion of an electronic-component-attached wiring substrate according to an embodiment of the present invention.
Fig. 2 is a view of the electronic component illustrated in Fig. 1 as viewed from an A side.
Fig. 3 is a cross-sectional view of a wiring substrate constituting the electronic-component-attached wiring substrate illustrated in Fig. 1.
Fig. 4 is a plan view of the wiring substrate illustrated in Fig. 3 as viewed from a B side.
Fig. 5 is a plan view of a wiring substrate according to a modification example of the embodiment of the present invention.
Fig. 6 is a diagram illustrating a manufacturing step of the electronic-component-attached wiring substrate according to the embodiment of the present invention (1).
Fig. 7 is a diagram illustrating the manufacturing step of the electronic-component-attached wiring substrate according to the embodiment of the present invention (2). Description of Embodiments

Hereinafter, embodiments in which the present invention is applied will be described in detail with reference to the drawings. In addition, the drawings used in the following description are for explaining a configuration of an embodiment of the present invention, and the sizes, thicknesses, dimensions, and the like of the respective parts shown in the drawings may be different from the actual dimensions of the electronic-component-attached wiring substrate and the wiring substrate.

### [Embodiment]

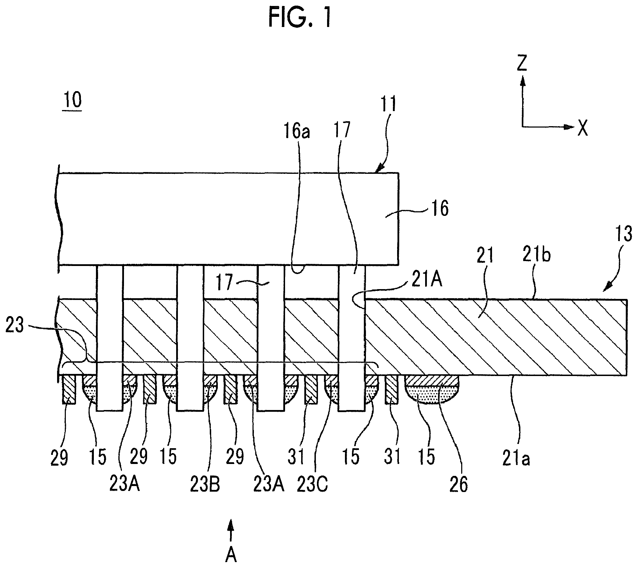

Fig. 1 is a cross-sectional view schematically illustrating an end portion of an electronic-component-attached wiring substrate according to an embodiment of the present invention. In Fig. 1, X direction represents the arrangement direction of a first insertion hole 21A (a first direction), and Z direction represents a direction orthogonal to the X direction and the thickness direction of an insulating substrate 21.

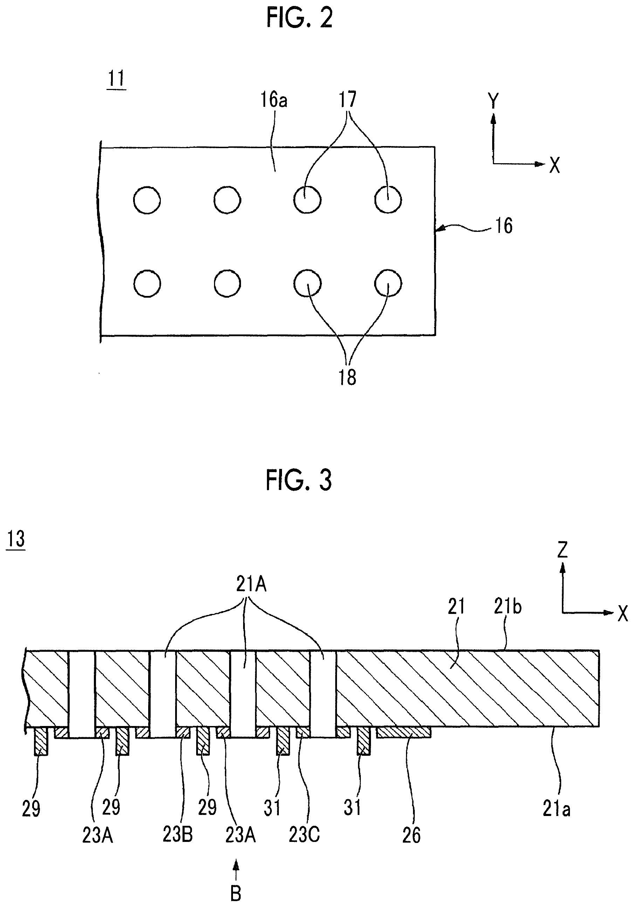

Fig. 2 is a view of the electronic component illustrated in Fig. 1 as viewed from an A side. In Fig. 2, Y direction represents a direction orthogonal to the X direction. In Fig. 2, the same components as those of the electronic-component-attached wiring substrate 10 shown in Fig. 1 are denoted by the same reference numerals.

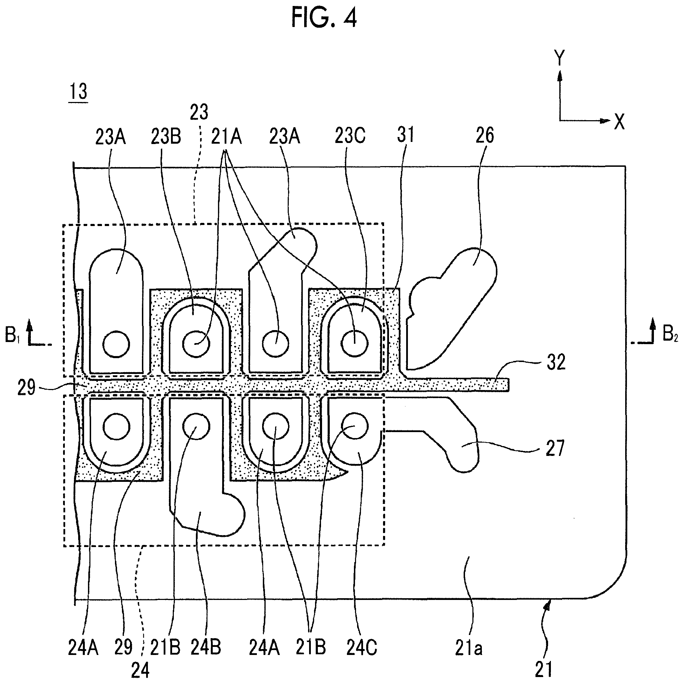

Fig. 3 is a cross-sectional view of a wiring substrate constituting the electronic-component-attached wiring substrate illustrated in Fig. 1. Fig. 3 is a view corresponding to the cross section taken along line B₁-B₂ shown in Fig. 4. In Fig. 3, the same components as those of the electronic-component-attached wiring substrate 10 shown in Fig. 1 are denoted by the same reference numerals.

Fig. 4 is a plan view of the wiring substrate illustrated in Fig. 3 as viewed from a B side. In Fig. 4, the same components as those of the structure shown in Figs. 1 and 3 are denoted by the same reference numerals.

Referring to Figs. 1 to 4, the electronic-component-attached wiring substrate 10 of the present embodiment includes an electronic component 11, a wiring substrate 13, and solders 15.

Referring to Figs. 1 and 2, the electronic component 11 includes a main body portion 16, a plurality of lead terminals 17 and 18.

The main body portion 16 includes an electronic component body (not shown), and a mold resin covering the electronic component body.

The plurality of lead terminals 17 are provided on one surface 16a side of the main body portion 16 while being electrically connected to the electronic component body (not shown).

The plurality of lead terminals 17 are arranged at predetermined intervals in the X direction. The plurality of lead terminals 17 project from the one surface 16a. The portion of the lead terminal 17 projecting from the one surface 16a extends in a direction (the Z direction shown in Fig. 1) orthogonal to the one surface 16a.

The plurality of lead terminals 18 are provided on one surface 16a side of the main body portion 16 while being electrically connected to the electronic component body (not shown).

The plurality of lead terminals 18 are arranged at predetermined intervals in the X direction. The plurality of lead terminals 18 are arranged to face the lead terminal 17 in the Y direction (in the present embodiment, the second direction).

The plurality of lead terminals 18 project from the one surface 16a. The portion of the lead terminal 18 projecting from the one surface 16a extends in a direction (the Z direction shown in Fig. 1) orthogonal to the one surface 16a.

Referring to Figs. 1 to 4, the wiring substrate 13 includes an insulating substrate 21, a first land group 23, a second land group 24, a first solder-retaining land section 26, a second solder-retaining land section 27, a wiring pattern (not shown), a barrier section 29, a first barrier section 31, and a second barrier section 32.

The insulating substrate 21 is a substrate which is rectangular, and includes a one surface 21a, the other surface 21b which is disposed opposite the one surface 21a, a plurality of first insertion holes 21A, and a plurality of second insertion holes 21B. The one surface 21a and the other surface 21b are flat.

The plurality of first insertion hole 21A are holes penetrating the insulating substrate 21 in the Z direction. The plurality of first insertion holes 21A are provided in a manner spaced apart from one another in the X direction (first direction).

The plurality of first insertion holes 21A penetrates any one land among first lands 23A, 23B or a first end land 23C, which will be described later.

The lead terminals 17 are inserted to the plurality of first insertion holes 21A, from the other surface 21b side of the insulating substrate 21. The lead terminals 17 inserted to the first insertion holes 21A project from any one land among the first lands 23A, 23B and the first end land 23C.

The plurality of second insertion holes 21B are holes penetrating the insulating substrate 21 in the Z direction. The plurality of second insertion holes 21B are provided in a manner spaced apart from one another in the X direction.

The plurality of second insertion holes 21B are disposed to face one first insertion hole 21A in he Y direction.

The plurality of second insertion holes 21B penetrates any one land among second lands 24A, 24B or a second end land 24C, which will be described later.

The lead terminals 18 are inserted to the plurality of second insertion holes 21B, from the other surface 21b side of the insulating substrate 21. The lead terminals 18 inserted to the second insertion holes 21B project from any one land among the second lands 24A, 24B and the second end land 24C.

As the base material of the insulating substrate 21 described above, it is possible to use, for example, a glass epoxy substrate (a substrate on which laminated glass fibers are impregnated with an epoxy resin).

In Figs. 1 and 2, although not shown, a metal film (for example, a plating film formed by plating) in contact with the lead terminal 17 or the lead terminal 18 may be provided on a surface of the insulating substrate 21 partitioning the first and second insertion holes 21A and 21B.

Further, as an example of the second direction, Fig. 3 illustrates the where the second direction is the Y direction, as an example, but a direction crossing the X and Y directions on a virtual plane passing through the X and Y directions is defined as a second direction, and a plurality of first and second insertion holes 21A and 21B may be arranged such that the first insertion holes 21A face the second insertion holes 21B in the second direction.

The first land group 23 is provided on the one surface 21a of the insulating substrate 21 so as to extend in the X direction. The first land group 23 has a plurality of first lands (specifically, a plurality of first lands 23A, 23B, and a first end land 23C).

With respect to the plurality of first lands 23A, 23B, the first land 23A and the first land 23B are arranged alternately at predetermined intervals from each other in the order of the first land 23A and the first land 23B, in the X direction.

The first land 23A is configured to be same as the first land 23B in the width in the X direction and to be longer than the first land 23B in the length in the Y direction.

Thus, a portion of the first land 23A which is longer than the first land 23B functions as a solder-retaining land.

The first end land 23C is a land disposed at the end in the X direction, among the plurality of first lands (specifically, the plurality of first lands 23A, 23B, and the first end land 23C).

The first end land 23C has the same shape of the first land 23B. The first end land 23C is provided at a position adjacent to the first land 23A provided at the extreme end, among the plurality of first lands 23A. The first end land 23C is disposed between the first land 23A provided at the extreme end and the first solder-retaining land section 26, in the X direction.

The potential of the first end land 23C is different from the potential of the first land 23A which is provided at a position adjacent to at least the first end land 23C.

The thicknesses of the first lands 23A, 23B, and the first end land 23C, which are described above, are configured to be equal.

The second land group 24 is provided on the one surface 21a of the insulating substrate 21 so as to extend in the X direction and along the first land group 23. The second land group 24 has a plurality of second lands (specifically, a plurality of second lands 24A, 24B, and a second end land 24C).

With respect to the plurality of second lands 24A, 24B, the second land 24A and the second land 24B are arranged alternately at predetermined intervals from each other in the order of the second land 24A and the second land 24B, in the X direction.

The second land 24A has the same shape of the first land 23B described above. In the Y direction, the second land 24A is disposed to face the first land 23A.

In the Y direction, the second land 24B is disposed to face the first land 23B. The second land 24B is configured to be same as the second land 24A in the width in the X direction and to be longer than the second land 24A in the length in the Y direction.

Thus, a portion of the second land 24B which is longer than the second land 24A functions as a solder-retaining land.

The second end land 24C is a land disposed at the end in the X direction, among the plurality of second lands (specifically, the plurality of second lands 24A, 24B and the second end land 24C).

The second end land 24C has the same shape of the second land 24A. The second end land 24C is provided at a position adjacent to the second land 24A provided at the extreme end, among the plurality of second lands 24A.

The second end land 24C is disposed between the second land 24A provided at the extreme end and the second solder-retaining land section 27, in the X direction.

The potential of the second end land 24C is different from the potentials of at least the first land 23A provided at a position adjacent to the first end land 23C, the first end land 23C, and the second land 24A provided at a position adjacent to the second end land 24C.

The thicknesses of the second land 24A, 24B, and the second end land 24C, which are described above, are configured to be equal to the thicknesses of the first land 23A, 23B, and the first end land 23C, which are described above.

The first solder-retaining land section 26 is provided at a position adjacent to the first end land 23C, on the one surface 21a of the insulating substrate 21 which is positioned in the X direction of the first end land 23C.

That is, the first solder-retaining land section 26 is provided at the end of the first land group 23.

The first solder-retaining land section 26 is disposed at a position spaced from the first end land 23C, and it is separated from the first end land 23C.

The first insertion hole 21A is not formed in the first solder-retaining land section 26. The outer shape and area of the first solder-retaining land section 26 is configured to be larger than the outer shape and area of the first end land 23C.

The potential of first solder-retaining land section 26 is the same as the potential of the first end land 23C. The thickness of the first solder-retaining land section 26 is configured to be equal to the thicknesses of the first lands 23A, 23B, and the first end land 23C, which are described above.

The second solder-retaining land section 27 is provided at a position adjacent to the second end land 24C, on the one surface 21a of the insulating substrate 21 which is positioned in the X direction of the second end land 24C.

That is, the second solder-retaining land section 27 is provided at the end of the second land group 24.

The second solder-retaining land section 27 is connected to the second end land 24C, and it is formed integrally with the second end land 24C.

The second insertion hole 21B is not formed in the second solder-retaining land section 27. The outer shape and area of the second solder-retaining land section 27 is configured to be larger than the outer shape and area of the second end land 24C.

The potential of the second solder-retaining land section 27 is the same as the potential of the second end land 24C. The thickness of the second solder-retaining land section 27 is configured to be equal to the thicknesses of the second lands 24A, 24B, and the second end land 24C, which are described above.

A plurality of wiring patterns (not shown) are provided on one surface 21a of the insulating substrate 21. The plurality of wiring pattern are connected to any land of the first lands 23A, 23B, the first end land 23C, the second lands 24A, 24B, and the second end land 24C.

A barrier section 29 has a property of repelling the solder 15, and is provided on one surface 21a of the insulating substrate 21. The barrier section 29 is provided so as to surround the periphery of the first land 23B and the second land 24A continuously. The barrier section 29 surrounding the first land 23B is connected to the barrier section 29 surrounding the second land 24A in the X direction.

Thus, the barrier section 29 has a portion extending continuously in the X direction between the first land 23A and the second land 24A, and between the first land 23B and the second land 24B.

It is preferable that the projected height of the barrier section 29 is made higher than, for example, the land disposed therearound.

The barrier section 29 suppresses the occurrence of solder bridges between the lands provided at adjacent positions (specifically, between the first lands 23A and 23B, between the first land 23A and the second land 24A, between the first land 23B and the second land 24B, and between the second lands 24A and 24B).

As the material of the barrier section 29, it is possible to use a silk material, for example. The silk material is a material used to print the position to mount the electronic component 11, the number or the like on one surface 21a of the insulating substrate 21, and a material used in manufacturing a wiring substrate, in the related art.

The first barrier section 31 is provided on one surface 21a of the insulating substrate 21 so as to surround the periphery of the first end land 23C continuously. The first barrier section 31 has a property of repelling the solder 15.

Of the four corner portions of the first barrier section 31, one corner is connected to the barrier section 29.

It is preferable that the projected height of the first barrier section 31 is made higher than, for example, the land disposed therearound.

Since the first end land 23C and the first solder-retaining land section 26 are separated from each other by providing the first barrier section 31 with such a configuration, as compared with the land in which the first end land 23C and the first solder-retaining land section 26 are integrally formed, it is possible to reduce the amount of solder 15 retained in the first solder-retaining land section 26.

Thus, the solder 15 retained in the first solder-retaining land section 26 can be prevented from easily moving to the first end land 23C.

Further, since the first barrier section 31 has the properties of repelling the solder 15, the solder 15 retained in the first solder-retaining land section 26 can be further prevented from moving to the first end land 23C, without increasing the area of the first solder-retaining land section 26.

Thus, it is possible to sufficiently suppress the occurrence of solder bridges between the lands disposed around the first end land 23C.

That is, it is possible to sufficiently suppress the occurrence of solder bridges around the first end land 23C, while suppressing an increase in the size of the wiring substrate 13.

In addition, Fig. 4 illustrates a case where the first barrier section 31 is disposed so as to continuously surround the periphery of the first end land 23C as an example, but the first barrier section 31 may be provided to separate at least the first end land 23C and the first solder-retaining land section 26 in the X direction. In this case, it is possible to obtain the effect described above.

The second barrier section 32 is provided on one surface 21a of the insulating substrate 21 so as to separate the first solder-retaining land section 26 and the second solder-retaining land section 27. The second barrier section 32 extends in the X direction, and one end is connected to the first barrier section 31. The second barrier section 32 has a property of repelling the solder 15.

It is preferable that the projected height of the second barrier section 32 is made higher than, for example, the land disposed therearound.

By providing the second barrier section 32 having this configuration, it is possible to suppress the occurrence of solder bridges between the first solder-retaining land section 26 and the second solder-retaining land section 27.

Further, by providing the first and second barrier sections 31, 32, described above, it is possible to suppress the occurrence of a short circuit due to the solder 15 between the land which is disposed around the first end land 23C and has a potential different from the first end land 23C and the first end land 23C.

The solder 15 is provided on a surface located opposite the surface in contact with the one surface 21a of the insulating substrate 21, among the surfaces of the plurality of first lands 23A, 23B, the first end land 23C, the plurality of second land 24A, 24B, the second end land 24C, the first solder-retaining land section 26, and the second solder-retaining land section 27.

The solders 15 provided in the first lands 23A, 23B and the first end land 23C electrically connects the first lands 23A, 23B and the first end land 23C with the lead terminal 17.

The solders 15 provided in the second lands 24A, 24B and the second end land 24C electrically connects the second lands 24A, 24B and the second end land 24C with the lead terminal 18.

Since the wiring substrate 13 of the present embodiment includes the first barrier section 31 having properties of repelling the solder 15, it is possible to sufficiently suppress the occurrence of solder bridges around the first end land 23C while suppressing an increase in the size of the wiring substrate 13.

Since the wiring substrate 13 includes the second barrier section 32 having properties of repelling the solder 15, it is possible to suppress the occurrence of solder bridges between the first solder-retaining land section 26 and the second solder-retaining land section 27.

Since the electronic-component-attached wiring substrate 10 of the present embodiment described above has the wiring substrate 13, it is possible to obtain the same effects as the wiring substrate 13.

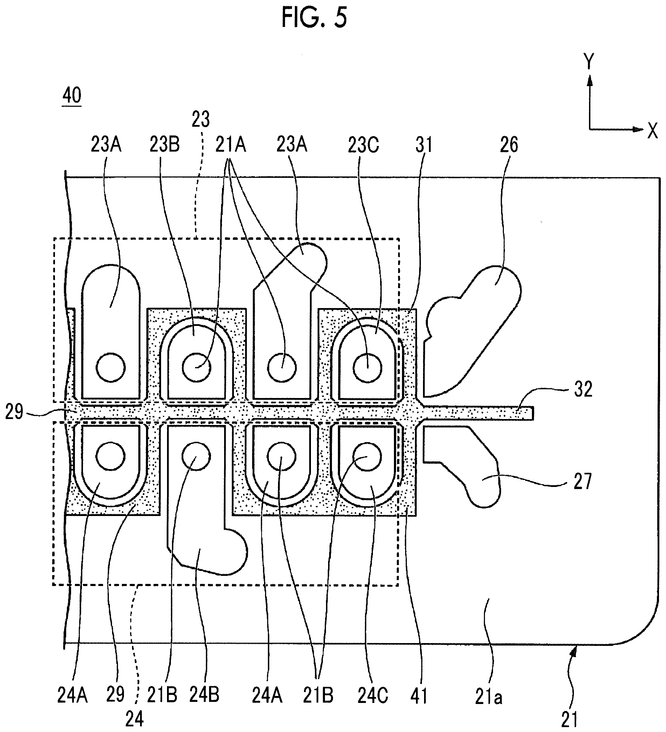

Fig. 5 is a plan view of a wiring substrate according to a modification example of the embodiment of the present invention. In Fig. 5, the same components as those of the structure shown in Fig. 4 are denoted by the same reference numerals.

Referring to Fig. 5, a wiring substrate 40 of the modification example of the present embodiment will be described.

The wiring substrate 40 has the same configuration as that of the wiring substrate 13 except that a third barrier section 41 is provided in addition to the configuration of the wiring substrate 13 of the present embodiment described above and the barrier section 29 disposed between the second end land 24C and the second land 24A is a part of the components of the third barrier section 41.

A third barrier section 41 has a property of repelling the solder 15, and is provided on one surface 21a of the insulating substrate 21. The third barrier section 41 is a U-shaped barrier section, and is disposed around the second end land 24C.

Both ends of the third barrier section 41 are connected to the first barrier section 31. Thus, the structure configured with the first and third barrier sections 31, 41 surrounds the second end land 24C.

It is preferable that the projected height of the third barrier section 41 is made higher than, for example, the land disposed therearound.

Since the wiring substrate 40 according to the modification example of the embodiment includes the third barrier section 41 that separates the second end land 24C and the second solder-retaining land section 27 and has a property of repelling the solder 15, the solder 15 retained in the second solder-retaining land section 27 can be prevented from moving to the second end land 24C, without increasing the area of the second solder-retaining land section 27.

Thus, it is possible to suppress the occurrence of solder bridges between the second solder-retaining land section 27 and the second end land 24C, while suppressing an increase in the size of the wiring substrate 40.

In Fig. 5, as an example, a case in which the U-shaped third barrier section 41 is provided has been described as an example, but the third barrier section 41 may be provided on one surface 21a of the insulating substrate 21 so as to separate at least the second end land 24C and the second solder-retaining land section 27.

Since the second end land 24C and the second solder-retaining land section 27 are separated from each other by providing the third barrier section 41 in such a position, as compared with the land in which the second end land 24C and the second solder-retaining land section 27 are integrally formed, it is possible to reduce the amount of solder retained in the second solder-retaining land section 27.

Thus, it is possible to suppress the occurrence of solder bridges between the second solder-retaining land section 27 and the second end land 24C, while suppressing an increase in the size of the wiring substrate 40.

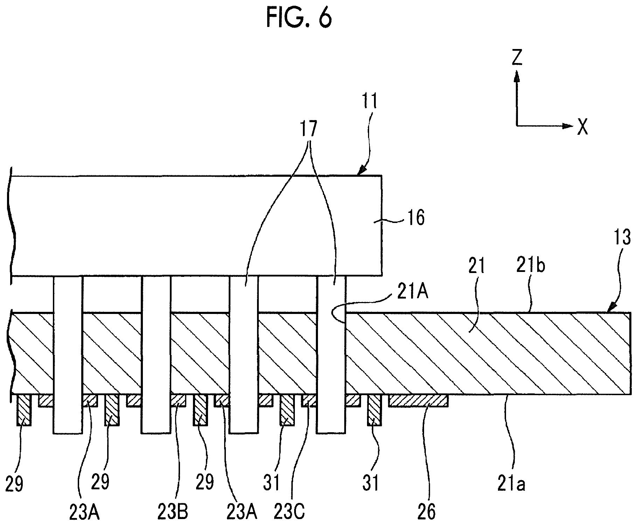

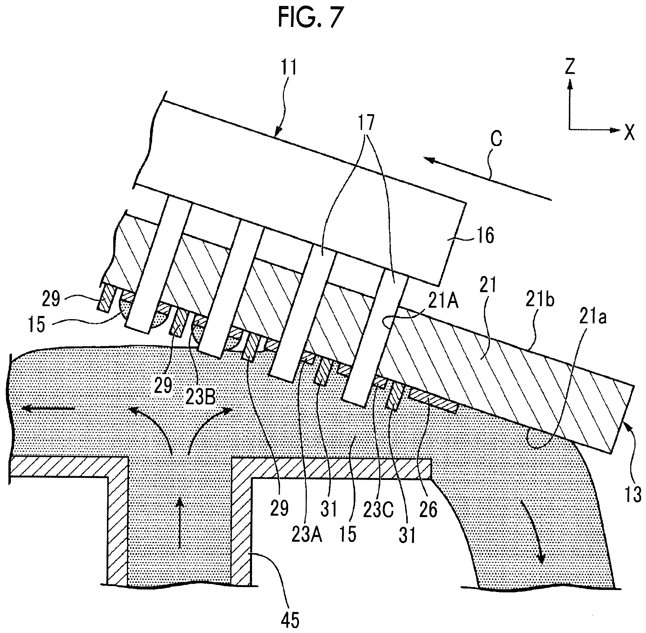

Figs. 6 and 7 are diagrams illustrating the manufacturing step of the electronic-component-attached wiring substrate according to the embodiment of the present invention. In Figs. 6 and 7, the same components as those of the structure shown in Figs. 1 to 5 are denoted by the same reference numerals. C shown in Fig. 7 indicates the transport direction of the wiring substrate 13 (hereinafter, referred to as "C direction").

Referring to Figs. 1 to 7, a method for manufacturing the electronic-component-attached wiring substrate 10 according to the embodiment of the present invention will be described.

First, by a known technique, the first land group 23, the second land group 24, the first solder-retaining land section 26 which is spaced from the first end land 23C, and the second solder-retaining land section 27 which is disposed at a position adjacent to the second end land 24C are collectively formed on one surface 21a of the insulating substrate 21 (first step).

Next, by a known technique, the first and second barrier sections 31, 32 are collectively formed (second step).

At this time, the first barrier section 31 may be formed so as to surround the first end land 23C.

In this manner, by forming the first barrier section 31 so as to surround the first end land 23C, the occurrence of solder bridges can be further suppressed between the land provided around the first end land 23C and the first end land 23C.

In the second step, the first and second barrier sections 31 and 32, for example, may be formed by a printing method using a silk material.

In this way, since the first and second barrier sections 31, 32 are formed by using the silk material used to print the position to mount the electronic component 11 or the number on one surface 21a of the insulating substrate 21, there is no need to prepare separately the material for forming the first and second barrier sections 31, 32, such that it is possible to conveniently form the first and second barrier sections 31, 32.

The materials of the first and second barrier section 31, 32 may be a material having solder repelling properties, and are not limited to the silk material.

By performing the first step and second step described above, the wiring substrate 13 shown in Fig. 3 is manufactured.

Next, in a step shown in FIG. 6, the lead terminals 17, 18 (see Fig. 2) of the electronic component 11 are inserted to the first and second insertion holes 21A, 21B (see Fig. 4) from the other surface 21b side of the insulating substrate 21 and the lead terminals 17, 18 are projected from the plurality of first and second lands 23A, 23B, 24A, 24B, and the first and second end lands 23C, 24C, provided on one surface 21a side of the insulating substrate 21 (third step).

Thus, the electronic component 11 is temporarily fixed on the wiring substrate 13.

Then, in a step shown in FIG. 7, a molten solder 15 ejected from the solder ejecting section 45 is attached to the plurality of first and second lands 23A, 23B and the first and second end lands 23C, 24C by a solder flow method, while transporting the wiring substrate 13 to which the electronic component 11 is inserted in the C direction, in a state where the wiring substrate 13 is tilted (fourth step).

In the fourth step, the wiring substrate 13 is transported in the transport direction (C direction) of the wiring substrate such that the first and second solder-retaining land sections 26, 27 are located at the rear end.

By transporting the wiring substrate 13 in such a state, finally, the first and second solder-retaining land sections 26, 27 are in contact with the molten solder 15.

Thus, the electronic-component-attached wiring substrate 10 shown in Fig. 1 is manufactured.

According to the method for manufacturing an electronic-component-attached wiring substrate of the present embodiment, the plurality of first and second lands 23A, 23B, 24A, 24B, and the first and second end lands 23C, 24C are formed by transporting the wiring substrate 13 to which the electronic component 11 is inserted in the transport direction of the wiring substrate 13 such that the first and second solder-retaining land sections 26, 27 are positioned on the rear end side, it becomes possible to prevent the solder 15 retained in the first solder-retaining land section 26 from moving to the adjacent land, without increasing the area of the first solder-retaining land section 26.

Thus, it is possible to sufficiently suppress the occurrence of solder bridges around the first end land 23C, while suppressing an increase in the size of the wiring substrate 13.

Although preferred embodiments of the present invention have been described in detail above, the present invention is not limited to such specific embodiments, various variations and modifications are possible within the scope of the present invention described in the claims.

### Industrial Applicability

The present invention is applicable to a wiring subs trate on which an electronic component having a plurality of lead terminals is mounted, an electronic-component-attached wiring substrate, and a method for manufacturing an electronic-component-attached wiring substrate.

### Reference Signs List

10 ELECTRONIC-COMPONENT-ATTACHED WIRING SUBSTRATE
11 ELECTRONIC COMPONENT
13, 40 WIRING SUBSTRATE
15 SOLDER
16 MAIN BODY PORTION
16a, 21a ONE SURFACE
17, 18 LEAD TERMINAL
21 INSULATING SUBSTRATE
21A FIRST INSERTION HOLE
21b OTHER SURFACE
21B SECOND INSERTION HOLE
23 FIRST LAND GROUP
23A, 23B FIRST LAND
23C FIRST END LAND
24 SECOND LAND GROUP
24A, 24B SECOND LAND
24C SECOND END LAND
26 FIRST SOLDER-RETAINING LAND SECTION
27 SECOND SOLDER-RETAINING LAND SECTION
29 BARRIER SECTION
31 FIRST BARRIER SECTION
32 SECOND BARRIER SECTION
41 THIRD BARRIER SECTION
45 SOLDER EJECTING SECTION
C DIRECTION

## Claims

1. A wiring substrate comprising:
an insulating substrate;
a first land group including a plurality of first lands having first insertion holes respectively which are provided in a manner spaced apart from one another in a first direction, on one surface of the insulating substrate, which penetrate the insulating substrate, and through which lead terminals are inserted;
a first solder-retaining land section that is provided adjacent to a first end land disposed at an end in the first direction, among the plurality of first lands; and
a first barrier section that is provided on the one surface of the insulating substrate so as to separate at least the first end land and the first solder-retaining land section in the first direction and that has solder repelling properties.

2. The wiring substrate according to claim 1,
wherein the first barrier section is disposed so as to continuously surround the periphery of the first end land.

3. The wiring substrate according to claim 1, further comprising:
a second land group including a plurality of second lands having second insertion holes respectively which are provided in a manner spaced apart from one another along the first land group in the first direction, on the one surface of the insulating substrate, which penetrate the insulating substrate, and through which lead terminals are inserted;
a second solder-retaining land section that is provided at the end in the first direction and is provided adjacent to a second end land that is disposed opposite the first end land in a second direction crossing the first direction, among the plurality of second lands; and
a second barrier section that is provided on the one surface of the insulating substrate, disposed so as to separate the first solder-retaining land section and the second solder-retaining land section, and is connected to the first barrier section,
wherein the second barrier section has the solder repelling properties.

4. The wiring substrate according to claim 3,
wherein the first end land and the first solder-retaining land section have the same potential as each other, and
wherein the second end land and the second solder-retaining land section have the same potential as each other, and have different potentials from the first end land and the first solder-retaining land section.

5. The wiring substrate according to claim 3 or 4, further comprising:
a third barrier section that is provided on the one surface of the insulating substrate so as to separate at least the second end land and the second solder-retaining land section in the first direction and that has solder repelling properties.

6. The wiring substrate according to claim 5,
wherein both ends of the third barrier section are connected to the first barrier section, and
wherein a structure including the first and third barrier sections surrounds the second end land.

7. An electronic-component-attached wiring substrate comprising:
the wiring substrate according to any one of claims 3 to 6;
an electronic component including a plurality of the lead terminals projecting from the other surface of the insulating substrate while being inserted into the first and second insertion holes; and
solders provided in the plurality of first lands, the plurality of second lands, the first solder-retaining land section, and the second solder-retaining land section.

8. A method for manufacturing an electronic-component-attached wiring substrate, comprising:
a first step of collectively forming a first land group including a plurality of first lands having first insertion holes respectively which penetrate an insulating substrate and through which lead terminals are inserted, on one surface of the insulating substrate; a second land group including a plurality of second lands having second insertion holes which penetrate the insulating substrate through which lead terminals are inserted; a first solder-retaining land section spaced from a first end land disposed at an end in the first direction, among the plurality of first lands; and a second solder-retaining land section that is disposed at a position adjacent to a second end land disposed at an end in the first direction, among the plurality of second lands;
a second step of collectively forming a first barrier section that separates at least the first end land and the first solder-retaining land section in the first direction and has solder repelling properties and a second barrier section that separates at least the second end land and the second solder-retaining land section and has solder repelling properties;
a third step of inserting the lead terminals of an electronic component into the first and second insertion holes from the other surface side of the insulating substrate, and causing the lead terminals to project from the plurality of first and second lands including the first and second end lands provided on the one surface side of the insulating substrate; and
a fourth step of attaching a molten solder to the plurality of first and second lands including the first and second end lands, while transporting a wiring substrate to which the electronic component is inserted in a predetermined direction, in a state where the wiring substrate is tilted, by a solder flow method,
wherein in the fourth step, the wiring substrate is transported in the transport direction of the wiring substrate such that the first and second solder-retaining land sections are located at the rear end.

9. The method for manufacturing an electronic-component-attached wiring substrate according to claim 8,
wherein in the second step, the first barrier section is formed so as to surround the first end land.

10. The method for manufacturing an electronic-component-attached wiring substrate according to claim 8 or 9,
wherein the first barrier section and the second barrier section are made by a printing method using a silk material.

## Amended claims

### Amended claims under Art. 19.1 PCT

1. [Amended] A wiring substrate comprising:
an insulating substrate;
a first land group including a plurality of first lands having first insertion holes respectively which are provided in a manner spaced apart from one another in a first direction, on one surface of the insulating substrate, which penetrate the insulating substrate, and through which lead terminals are inserted;
a first solder-retaining land section that is provided adjacent to a first end land disposed at an end in the first direction, among the plurality of first lands; and
a first barrier section that is provided on the one surface of the insulating substrate so as to separate at least the first end land and the first solder-retaining land section in the first direction and that has solder repelling properties,
wherein the height of the first barrier section is made higher than the first end land and the first solder-retaining land section.

2. The wiring substrate according to claim 1,
wherein the first barrier section is disposed so as to continuously surround the periphery of the first end land.

3. The wiring substrate according to claim 1, further comprising:
a second land group including a plurality of second lands having second insertion holes respectively which are provided in a manner spaced apart from one another along the first land group in the first direction, on the one surface of the insulating substrate, which penetrate the insulating substrate, and through which lead terminals are inserted;
a second solder-retaining land section that is provided at the end in the first direction and is provided adjacent to a second end land that is disposed opposite the first end land in a second direction crossing the first direction, among the plurality of second lands; and
a second barrier section that is provided on the one surface of the insulating substrate, disposed so as to separate the first solder-retaining land section and the second solder-retaining land section, and is connected to the first barrier section,
wherein the second barrier section has the solder repelling properties.

4. The wiring substrate according to claim 3,
wherein the first end land and the first solder-retaining land section have the same potential as each other, and
wherein the second end land and the second solder-retaining land section have the same potential as each other, and have different potentials from the first end land and the first solder-retaining land section.

5. The wiring substrate according to claim 3 or 4, further comprising:
a third barrier section that is provided on the one surface of the insulating substrate so as to separate at least the second end land and the second solder-retaining land section in the first direction and that has solder repelling properties.

6. The wiring substrate according to claim 5,
wherein both ends of the third barrier section are connected to the first barrier section, and
wherein a structure including the first and third barrier sections surrounds the second end land.

7. An electronic-component-attached wiring substrate comprising:
the wiring substrate according to any one of claims 3 to 6;
an electronic component including a plurality of the lead terminals projecting from the other surface of the insulating substrate while being inserted into the first and second insertion holes; and
solders provided in the plurality of first lands, the plurality of second lands, the first solder-retaining land section, and the second solder-retaining land section.

8. (Amended) A method for manufacturing an electronic-component-attached wiring substrate, comprising:
a first step of collectively forming a first land group including a plurality of first lands having first insertion holes respectively which penetrate an insulating substrate and through which lead terminals are inserted, on one surface of the insulating substrate; a second land group including a plurality of second lands having second insertion holes through which lead terminals passing through the insulating substrate are inserted; a first solder-retaining land section spaced from a first end land disposed at an end in the first direction, among the plurality of first lands; and a second solder-retaining land section that is disposed at a position adjacent to a second end land disposed at an end in the first direction, among the plurality of second lands;
a second step of collectively forming a first barrier section that separates at least the first end land and the first solder-retaining land section in the first direction and has solder repelling properties and a second barrier section that separates at least the second end land and the second solder-retaining land section and has solder repelling properties;
a third step of inserting the lead terminals of an electronic component into the first and second insertion holes from the other surface side of the insulating substrate, and causing the lead terminals to project from the plurality of first and second lands including the first and second end lands provided on the one surface side of the insulating substrate; and
a fourth step of attaching a molten solder to the plurality of first and second lands including the first and second end lands, while transporting a wiring substrate to which the electronic component is inserted in a predetermined direction, in a state where the wiring substrate is tilted, by a solder flow method,
wherein in the fourth step, the wiring substrate is transported in the transport direction of the wiring substrate such that the first and second solder-retaining land sections are located at the rear end, and
wherein in the second step, the first barrier section is formed to have a height higher than the first end land and the first solder-retaining land section, and the second barrier section is formed to have a height higher than the second end land and the second solder-retaining land section.

9. The method for manufacturing an electronic-component-attached wiring substrate according to claim 8,
wherein in the second step, the first barrier section is formed so as to surround the first end land.

10. The method for manufacturing an electronic-component-attached wiring substrate according to claim 8 or 9,
wherein the first barrier section and the second barrier section are made by a printing method using a silk material.

Statement under Art. 19.1 PCT
Claims 1 and 8 of the claims are amended according to the attached sheet. That is, the limitation (ground for correction; paragraph 0059) was added to Claim 1 before amendment. The limitation (ground for correction; paragraph 0059 and paragraph 0063) was added to Claim 8 before amendment.
